# EUROPÄISCHE PATENTSCHRIFT

(11) **EP 3 139 715 B1**
(45) Veröffentlichungstag und Bekanntmachung des Hinweises auf die Patenterteilung: **25.05.2022**
(21) Anmeldenummer: 16184640.7
(22) Anmeldetag: 18.08.2016
(51) Int. Cl.: H05K 5/06

(54) **ABDICHTUNG VON LEITERPLATTENGEHÄUSEN**
SEALING OF CONDUCTOR PANEL HOUSINGS
ÉTANCHEIFICATION DE BOITIERS DE CARTES DE CIRCUITS IMPRIMES

(30) Priorität: 01.09.2015 DE 202015104630 U
(43) Veröffentlichungstag der Anmeldung: 08.03.2017
(73) Patentinhaber: Tridonic GmbH & Co KG, 6851 Dornbirn (AT)
(72) Erfinder: Steiner, Sascha, 6900 Bregenz (AT); Weber, Wolfgang, 6927 Fußach (AT)
(74) Vertreter: Beder, Jens

(56) Entgegenhaltungen:
- EP-A1- 2 040 527
- DE-A1-102005 059 082
- DE-T5-112006 002 303
- JP-A- H09 321 446
- US-A- 5 009 311

## Beschreibung

Die Erfindung bezieht sich auf eine elektronische Vorrichtung, die ein Gehäuse und eine in das Gehäuse eingesetzte Leiterplatte umfasst. Insbesondere bezieht sich die Erfindung auf eine elektronische Vorrichtung, die für den Einsatz im Außenbereich isolierend mit einer Vergussmasse vergossen ist.

Es ist bekannt elektronische Geräte für den Einsatz im Außenbereich mit einer isolierenden Vergussmasse (Vergussmaterial) zu vergießen. Dies trifft insbesondere auch auf Betriebsgeräte und Steuergerät für Leuchten im Außenbereich zu. So sind auch Konverter für Leuchtdioden (LEDs) häufig für den Betrieb unter feuchten Umgebungsbedingungen und starken Temperaturschwankungen derart ausgeführt.

Üblicherweise sind diese elektronischen Geräte und Baugruppen mit einem becherartigen Gehäuse gefertigt. Dabei wird eine Leiterplatte in einen einseitig offenen Becher eingesetzt. Der einseitig offene Becher wird anschließend mit der Vergussmasse befüllt, um die auf der Leiterplatte untergebrachte Elektronik vor Spritzwasser zu schützen. Anschlüsse befinden sich nur auf einem aus der Vergussmasse herausragenden Ende der Leiterplatte.

Nachteilig an dem vorgestellten Aufbau entsprechend dem Stand der Technik ist, dass lediglich an einer Seite der Leiterplatte Anschlussklemmen zur Kontaktierung der Leiterplatte untergebracht werden können. Lediglich an der offenen Seite des Bechers besteht die Möglichkeit, dass nach dem Vergießen die Anschlussklemmen aus der Vergussmasse herausstehen können. Um eine große Anzahl von Anschlüssen für eine so gefertigte Baugruppe zu verwirklichen, muss daher eine erhöhte Breite der Leiterplatte zur Aufnahme der Anschlüsse, mithin auch eine größere Tiefe der Baugruppe in Kauf genommen werden. Die Abmessungen der elektronischen Baugruppe werden durch die Forderung nach einer spritzwassergeschützten Ausführung demzufolge ungünstig beeinflusst.

Eine elektronische Vorrichtung gemäß dem Oberbegriff des beigefügten Anspruches 1 ist in der DE 10 2005 059 082 A1 beschrieben.

Die EP 2 040 527 A1 offenbart ein aus zwei Teilen bestehendes Elektronikgehäuse, in dem eine Leiterplatte angeordnete ist und das eine Einfüllöffnung für eine Vergussmasse aufweist.

Die DE 11 2006 002303 T5 offenbart ein Sensor-Modul, mit einem Gehäuse, einer in dem Gehäuse untergebrachten Leiterplatte, und einem zwischen einer Seite der Leiterplatte und dem Gehäuse angeordneten Kriechweg für eine Vergussmasse.

Die US 5 009 311 A offenbart eine elektronische Vorrichtung umfassend eine Leiterplatte und ein Gehäuse zur Aufnahme der Leiterplatte, wobei das Gehäuse eine erste Öffnung zum Einsetzen der Leiterplatte aufweist und die eingesetzte Leiterplatte diese Öffnung des Gehäuses im Wesentlichen verschließt.

JP H09 321446 A offenbart eine elektronische Vorrichtung, wobei das Gehäuse nur teilweise mit einer Leiterplatte verschlossen ist.

Ausgehend von dem eingangs dargestellten Stand der Technik wendet sich die Erfindung der technischen Aufgabe zu, die Auslegung vergossener elektronischer Baugruppen zu verbessern.

Die technische Aufgabe wird durch die elektronische Vorrichtung nach Anspruch 1 gelöst. Die abhängigen Ansprüche enthalten vorteilhafte Weiterbildungen der Erfindung.

Eine erfindungsgemäße elektronische Vorrichtung umfasst eine Leiterplatte und ein Gehäuse zur Aufnahme der Leiterplatte. Das Gehäuse weist eine erste Öffnung zum Einsetzen der Leiterplatte auf, wobei die eingesetzte Leiterplatte das Gehäuse im Wesentlichen verschließt. Zudem ist ein Mittel zum Durchtritt von Vergussmasse vorhanden, durch das ein Volumen bei Vergießen des Gehäuses befüllbar ist, das nach Einsetzen der Leiterplatte in das Gehäuse zwischen der Leiterplatte einerseits und dem Gehäuse andererseits auf der von der Öffnung abgewandten Seite der Leiterplatte besteht.

Die erfindungsgemäße Vorrichtung ist damit geeignet, ein Vergießen der elektronischen Vorrichtung nach Einsetzen der Leiterplatte durch die Leiterplatte hindurch oder in an die Leiterplatte anschließenden Bereichen oder durch das Gehäuse hindurch vornehmen zu können. Damit stehen große Flächen für die Aufbringung von Kontaktelementen zur Kontaktierung einer auf der Leiterplatte elektrischen Schaltung zur Verfügung. Erfindungsgemäß wird die Leiterplatte nun so in die erste Öffnung in das Gehäuse eingesetzt, dass sie zumindest ein Teilvolumen des Gehäuses im Wesentlichen verschließt, wenn die Leiterplatte in ihrer beabsichtigten Position ist. Dennoch ist durch das erfindungsgemäße Mittel zum Durchtritt von Vergussmasse ein vollständiges Vergießen elektronischen Vorrichtung möglich. Damit ist eine erheblich freiere Wahl der Gehäusegeometrie möglich.

Weiter können das Einsetzen der Leiterplatte in das Gehäuse und das Befüllen des Gehäuses mit flüssiger Vergussmasse in eine Richtung erfolgen, so dass die erfindungsgemäße elektronische Vorrichtung fertigungstechnisch vorteilhaft ausgelegt ist.

Erfindungsgemäß zeichnet sich die elektronische Vorrichtung dadurch aus, dass eine Dichtungsanordnung, die eine zweite Öffnung des Gehäuses umgibt, die Leiterplatte gegen das Gehäuse abdichtet, so dass nach dem Einsetzen der Leiterplatte in das Gehäuse bei Vergießen der elektronischen Vorrichtung eine flüssige Vergussmasse durch die zweite Öffnung aus dem Gehäuse nicht austritt, also zurückgehalten wird. Die zweite Öffnung in dem Gehäuse ist so positioniert ist, dass ein mit der Leiterplatte verbundenes Kontaktelement, Einstellelement und/oder Anzeigeelement durch die zweite Öffnung nach dem Einsetzen der Leiterplatte in das Gehäuse und dem Vergießen zugänglich ist.

Damit können auf der Leiterplatte Bauelemente angeordnet werden, die mittels der zweiten Öffnung extern zugänglich sind oder über die zweite Öffnung aus einem inneren Bereich des Gehäuses in den Bereich außerhalb des Gehäuses hinausragen. Die Möglichkeit, nach dem Vergießen der elektronischen Vorrichtung zugängliche Bauelemente auf der Leiterplatte vorzusehen, wird so erheblich vergrößert. Im Gegensatz zu der becherartigen Gehäusekonfiguration bestehen infolge der, mittels der Dichtungsanordnung abgedichtete zweite Öffnungen des Gehäuses mehr Freiheitsgrade bei dem Entwurf geeigneter Gehäusegeometrien und Anordnung von Anschlüssen.

Das Gehäuse weist zudem Stützelemente, deren zu der ersten Öffnung hin gerichtete Abschlussfläche zumindest teilweise die Leiterplatte stützt, auf, wobei, die Stützelemente hohl ausgebildet sind, Durchtrittsöffnungen in einer Umfangsfläche der Stützelemente einen Austritt der Vergussmasse in das Volumen, das nach dem Einsetzen der Leiterplatte in das Gehäuse zwischen der Leiterplatte und dem Gehäuse besteht, ermöglichen und der Eintritt der Vergussmasse in das hohle Stützelement über eine Eintrittsöffnung in der Abschlussfläche des Stützelements erfolgen kann Insbesondere ist es vorteilhaft, wenn die Dichtungsanordnung eine plane Fläche des Gehäuses umfasst, die mit einer korrespondierenden Fläche der Leiterplatte dichtend zusammenwirkt.

Die korrespondierende Fläche kann beispielsweise eine teilweise kupferkaschierte Fläche der Leiterplatte sein. Durch besonders ebene Ausführung der Flächen ist unter Anwendung einer Flächenpressung auf die Leiterplatte in Richtung auf die zweite Öffnung zu eine besonders dichte Ausführung der Dichtungsanordnung erzielbar ohne zusätzliche Dichtmittel zu benötigen.

Entsprechend einer Ausführung der erfindungsgemäßen elektronischen Vorrichtung umfasst die Dichtungsanordnung mindestens einen Steg mit keilförmigem und/oder trapezförmigem Querschnitt.

Eine elektronische Vorrichtung nach einer weiteren Ausführung der Erfindung weist die Dichtungsanordnung so ausgebildet aus, dass sie mindestens eine Dichtschnur (Dichtfaden) umfasst.

Eine elektronische Vorrichtung entsprechend einem weiteren Ausführungsbeispiel der Erfindung ist dadurch gekennzeichnet, dass die Dichtungsanordnung eine Dichtmasse umfasst, die nach dem Einsetzen der Leiterplatte mit dem Gehäuse dichtend zusammenwirkt. Die Dichtmasse kann auf der Leiterplatte und/oder auf dem Gehäuse aufgebracht werden und sich insbesondere elastisch Verformen.

Nach einer Ausführung der elektronischen Vorrichtung ist zumindest ein Halteelement ausgebildet, das eine Kraft auf die Leiterplatte in eine Richtung auf die zweite Öffnung des Gehäuses ausübt. Damit ist eine besonders gut Wirkung der Dichtungsanordnung erzielbar.

Eine vorteilhafte elektronische Vorrichtung hat ein Gehäuse das wannenförmig oder trogförmig ausgebildet ist.

Bevorzugt hat die elektronische Vorrichtung ein Gehäuse mit mindestens einer zweiten Öffnung in einem ersten Bereich des Gehäuses, wobei ein zweiter Bereich des Gehäuses eine größere Tiefe als der erste Bereich des Gehäuses hat. Damit ist eine einseitige Bestückung der Leiterplatte sowohl mit zu vergießenden Bauelementen und Schaltungsabschnitten innerhalb eines Trogvolumens, als auch mit nach Abschluss des Herstellungsprozesses von außen zugänglichen Bauelementen möglich.

Eine elektronische Vorrichtung entsprechend einem weiteren Ausführungsbeispiel der Erfindung ist dadurch gekennzeichnet, dass das Gehäuse in dem Volumen zwischen dem Gehäuse und der Leiterplatte, und mindestens teilweise in einem weiteren Volumen zwischen der Leiterplatte und dem Rand der Gehäuse, der die erste Öffnung umgibt, mit der Vergussmasse befüllt ist.

Eine elektronische Vorrichtung gemäß einer vorteilhaften Ausführung umfasst das Mittel zum Durchtritt der Vergussmasse umfassend zumindest eine Öffnung und/oder Ausnehmung der Leiterplatte.

Weiter ist es vorteilhaft, wenn das Mittel zum Durchtritt der Vergussmasse zumindest eine Öffnung und/oder Ausnehmung und/oder Kanal des Gehäuses umfasst.

Entsprechend einer Ausführung der elektronischen Vorrichtung ist die elektronische Vorrichtung ein Steuergerät und/oder ein Betriebsgerät.

Die Erfindung wird nachfolgend anhand von Ausführungsbeispielen und Figuren näher erläutert. Es zeigen
- Fig. 1: eine Ansicht eines erfindungsgemäßen Gehäuses und einer Leiterplatte vor Einsetzen der Leiterplatte,
- Fig. 2: eine schematische (Teil-) Darstellung der erfindungsgemäßen elektronischen Vorrichtung,
- Fig. 3: eine schematische der Darstellung eines Beispiels für eine Dichtungsanordnung gemäß einer Ausführung der Erfindung,
- Fig. 4: eine schematische der Darstellung eines weiteren Beispiels für die Dichtungsanordnung gemäß einer weiteren Ausführung der Erfindung,
- Fig. 5: eine schematische Darstellung eines weiteren Beispiels für die Dichtungsanordnung gemäß einer weiteren Ausführung der Erfindung,

In den Figuren bezeichnen gleiche Bezugszeichen dieselben oder entsprechende Elemente. Aus Gründen der Darstellung wird in der folgenden Beschreibung vorteilhafter Ausführungsbeispiele auf eine Wiederholung weitgehend verzichtet.

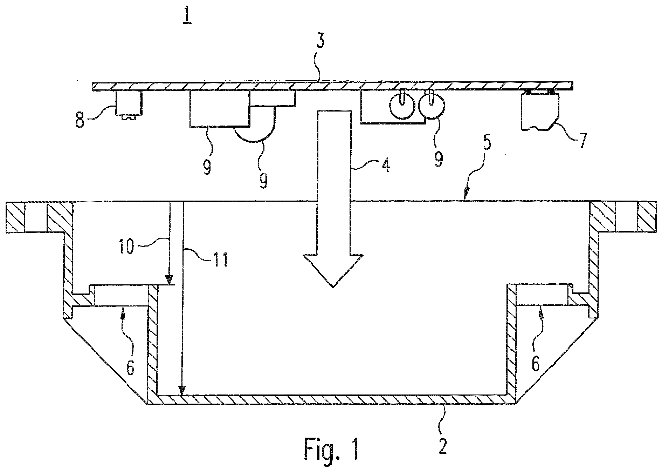

In Figur 1 sind in einer Ansicht ein erfindungsgemäßes Gehäuse 2 und eine Leiterplatte 3 vor Einsetzen der Leiterplatte 3 in das Gehäuse gezeigt. Dargestellt ist in der Figur 1 ebenfalls die Richtung (Einsetzrichtung, Fügerichtung) des Einsetzens der Leiterplatte 3 in das Gehäuse 2 durch einen Richtungspfeil 4.

Das Gehäuse 2 ist trogförmig (wannenförmig) ausgebildet. Eine erste Öffnung 5 des Gehäuses 2 erstreckt sich im Wesentlichen über eine gesamte (Ober-) Seite des Gehäuses. Die Leiterplatte 3 wird durch die erste Öffnung 5 in das Gehäuse 2 eingesetzt. Die erste Öffnung 5 wird daher bevorzugt Abmessungen aufweisen, die über den Abmessungen der Leiterplatte 3 liegen. Insbesondere werden Länge und Breite der ersten Öffnung 5 etwas größer als korrespondierende Länge und die Breite der Leiterplatte 3 sein, um eine problemlose Montage zu ermöglichen.

Das Gehäuse 2 in Figur 1 weist Bereiche unterschiedlicher Tiefe auf. In einem ersten Bereich um die zweite Öffnung 6 hat das Gehäuse 3 eine erste Tiefe 10. In einem zweiten Bereich des Gehäuses 3 hat das Gehäuse 3 eine zweite Tiefe 11. In dem in Figur 1 dargestellten Fall ist die erste Tiefe 10 des Gehäuses 3 geringer als die zweite Tiefe 11 des Gehäuses 3.

Gezeigt sind beispielsweise in Figur 1 zwei erste Bereiche mit einer geringeren Tiefe 10. Es kann im Rahmen der erfindungsgemäßen elektronischen Vorrichtung 1 ebenso kein erster Bereich, oder auch eine Mehrzahl erster Bereiche vorhanden sein.

Die Leiterplatte 3 kann beispielsweise eine kupferkaschierte Leiterkarte sein, auf der eine gedruckte Schaltung aufgebracht ist. Die Leiterplatte 3 kann eine oder mehrere Ebenen, beispielsweise einseitig, zweiseitig oder mehrlagig aus elektrisch isolierenden Material, beispielsweise faserverstärkter Kunststoff mit darauf und gegebenenfalls dazwischen liegenden Ebenen mit leitenden Verbindungen (Leiterbahnen), beispielsweise einer dünnen Schicht Kupfer, umfassen. Die Leiterplatte 3 dient der elektrischen Verbindung und der mechanischen Befestigung von Bauelementen 9. Die Bauelemente 9 können auf einer Seite oder auf beiden Seiten der Leiterplatte montiert (bestückt) sein. Die elektrische und mechanische Verbindung der Bauelemente mit der Leiterplatte 3 und den Leiterbahnen kann über Lötflächen oder Lötaugen erfolgen.

Die mit Bauelementen bestückte Leiterplatte 3 kann beispielsweise die Funktion eines Leuchtenbetriebsgeräts, eines Konverters für Leuchtmittel, insbesondere auch für den Einsatz im Außenbereich bereitstellen.

Auf der Leiterplatte 3 können auch weitere Bauelemente wie Kontaktelemente 7 oder Einstellelemente 8 bestückt sein. Als Kontaktelemente 7 werden im Folgenden Bauelemente wie beispielsweise Klemmen bezeichnet, die eine lösbare Verbindung oder einen Anschluss von Drähten (Adern, Leitungen) ermöglichen. Klemmen können in Form von Klemmleisten eine Vielzahl von Verbindungsmöglichkeiten bieten und entsprechend große Abmessungen aufweisen. Kontaktelemente 7 sollen von außerhalb des Gehäuses zugänglich sein, insbesondere auch nach Abschluss des Fertigungsprozesses. Über Kontaktelemente 7 können beispielsweise ein oder mehrere Leuchtmittel mittels Anschlusskabel mit der elektronischen Vorrichtung 1 verbunden sein.

Einstellelemente 8 sind Bauelemente, beispielsweise Potentiometer, deren elektrische Kennwerte, beispielsweise ein Widerstandswert, oder eine elektrische Verbindung mechanisch veränderbar ist. Die mechanische Veränderung kann beispielsweise über einen Drehknopf, einen Schieber, einen oder mehrere Schalter erfolgen.

Anzeigeelemente sind Elemente wie beispielsweise Leuchtdioden, die im Betrieb beispielsweise über Lichtabgabe einen Vorgang oder Zustand signalisieren.

Die erfindungsgemäße elektronische Vorrichtung 1 einzelner Ausführungsformen weist Kontaktelemente, Einstellelemente, Anzeigeelemente als Bauelemente auf, die auch nach Einsetzen der Leiterplatte 3 in das Gehäuse 2 und Vergießen zugänglich sind. Dazu verfügt das Gehäuse 2 über zumindest eine, in der Darstellung nach Figur 1 über zwei zweite Öffnungen 6. Die zweiten Öffnungen 6 sind im Gehäuse 3 so positioniert, dass bei in das Gehäuse 3 eingesetzter Leiterplatte 2 Bauelemente 7, 8, die nach der Fertigung der elektronischen Vorrichtung 1 zugänglich sein müssen, durch die zweite Öffnung 6 aus dem Gehäuse 2 hinausragen oder aber durch die zweite Öffnung 6 in ihren wesentlichen Funktionen, beispielsweise Drehknöpfe, zugänglich sind.

Beispielsweise kann ein Kontaktelement 7 nach Einsetzen der Leiterplatte 3 in das Gehäuse 2 durch die zweite Öffnung 6 in den Bereich außerhalb des Gehäuses 2 ragen, so dass eine Leiterader an das Kontaktelement 7 anschließbar ist. Ebenso kann ein Einstellelement 8 durch die zweite Öffnung 6 aus dem Gehäuse 2 hinausragen, so dass ein Drehknopf des Einstellelements zugänglich ist, wenn die Leiterplatte 3 in das Gehäuse 2 eingesetzt ist.

Eine Befestigung der Leiterplatte 3 in dem Gehäuse 2 ist in Figur 1 nicht dargestellt. Eine solche Befestigung ist beispielsweise mittels Schrauben, Kleben oder mittels besonderer, am Gehäuse ausgebildeter Halteelemente möglich. So kann beispielsweise eine Flächenpressung durch Halteelemente (z.B. thermisch verformbare Kunstoffnasen oder Rasthaken) an dem Gehäuse auf die Leiterplatte 3 in Richtung auf die zweite Öffnung 6 erfolgen.

Nicht dargestellt in Figur 1 ist eine Abdeckung der ersten Öffnung 5 durch einen Gehäusedeckel. Der Gehäusedeckel kann Befestigungselemente, beispielsweise säulenartige Befestigungselemente aufweisen. Diese Befestigungselemente können nach Aufsetzen und Fixieren des Gehäusedeckels auf dem Gehäuse 2 mit einer Fläche an der Leiterplatte 3 anliegen und diese mit in Richtung auf die zweiten Öffnung 6 drücken.

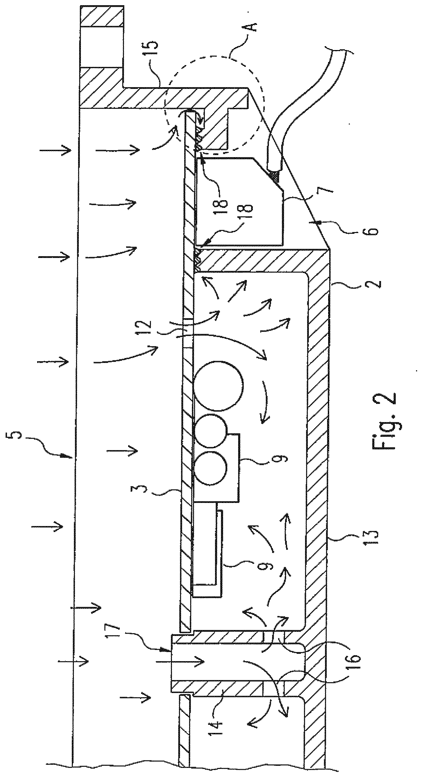

Im Folgenden wird unter Bezug auf die Figur 2 der Vorgang des Vergießens der erfindungsgemäßen elektronischen Vorrichtung 1 erläutert.

Insbesondere elektronische Vorrichtungen 1 für den Außenbereich werden mit einem Vergussmasse (Vergussmaterial) vergossen. Das Vergießen erfüllt die Aufgaben wie Umhüllung und Schutz gegen Fremdkörper, Wasser, Staub, ... Vergießen ist zugleich ein Mittel der elektrischen Isolation von spannungsführenden Teilen der elektronischen Vorrichtung 1 untereinander, um die Spannungsfestigkeit zu erhöhen und einen Berührungsschutz zu gewährleisten. Zugleich dient Vergießen einer Erhöhung der mechanischen Stabilität und damit auch einer Verbesserung der Vibrations- und Stoßfestigkeit der elektronischen Vorrichtung 1.

Als Vergussmasse kann beispielsweise ein Kunstharz, beispielsweise Gießharz verwendet werden. Die Vergussmasse kann in flüssiger Form in das Gehäuse 2 eingebracht (gegossen) werden und erstarrt. Die Erstarrung kann durch eine chemische Reaktion in irreversibler Form oder durch ein Erkalten der erhitzten Vergussmasse erfolgen.

Der eigentliche Vergussvorgang erfolgt so, dass möglichst keine Lufteinschlüsse verbleiben. Dies kann durch Vergießen aus einer Richtung, beispielsweise von unten, und gleichzeitigem Entweichen der Luft durch eine Öffnung, beispielsweise nach oben, erfolgen.

Nach dem Vergießen mit der flüssigen Vergussmasse kann ein Aushärten der Vergussmasse, beispielsweise mittels Wärmezufuhr, erfolgen.

Die erfindungsgemäße elektronische Vorrichtung 1 nach Figur 2 kombiniert eine Reihe vorteilhafter Merkmale einzelner Ausführungsbeispiele der Erfindung. Gezeigt ist die elektronische Vorrichtung 1 nach Einsetzen der Leiterplatte 3 in das Gehäuse 2. Das Vergießen der elektronischen Vorrichtung erfolgt mit der flüssigen Vergussmasse durch die erste Öffnung 5 und damit durch dieselbe Öffnung wie das Einsetzen der Leiterplatte 3 in das Gehäuse 2. Der Verguss kann maschinell oder manuell erfolgen. Das Vergießen kann in Vakuum durchgeführt werden. In Figur 2 zeigen Pfeile beispielhaft mögliche Wege der flüssigen Vergussmasse.

Dabei erfolgt das Vergießen durch Öffnungen und/oder Ausnehmungen in der Leiterplatte 3 hindurch. Öffnungen 12 in der Leiterplatte ermöglichen den Durchtritt von flüssiger Vergussmasse. Ebenso können Ausnehmungen am Rand der Leiterplatte eine Durchtritt der flüssigen Vergussmasse ermöglichen. Diese Ausnehmungen können mit entsprechenden Ausnehmungen in dem Gehäuse 2 zusammenwirken, um der Vergussmasse Ausbreitungswege zu schaffen. Ebenso können in dem Gehäuse, oder in Figur 2 nicht gezeigten Gehäuserippen des Gehäuses 3 Kanäle für flüssige Vergussmasse vorgesehen sein. Ebenso können weitere Öffnungen in einem Gehäuseboden 13 angeordnet sein. Flüssige Vergussmasse kann durch einen Spalt zwischen einer Umfangsebene der Leiterplatte 3 und einer Innenseite der Gehäuseseitenwand 15 um die Leiterplatte 3 herum treten.

Das erfindungsgemässe Gehäuse weist Stützelemente 14 auf. Die Stützelemente 14 sind so geformt, dass, sie mit mindestens einem Teil ihrer Abschlussfläche, die der ersten Öffnung 5 zugewandt ist, die Leiterplatte 3 stützen. Im Inneren der Stützelemente 14 ist ein Kanal angeordnet, der so geformt ist, dass er flüssige Vergussmasse zu einer oder mehreren Durchtrittsöffnungen 16 in einer Wand der Stützelemente 14 führen kann. Durch den Kanal und die Durchtrittsöffnungen 16 kann flüssige Vergussmasse in ein Volumen (erstes Teilvolumen) des Gehäuses 2, das sich zwischen der, der zweiten Öffnung 6 zugewandten Seite der Leiterplatte 3 und einer Innenseite des Gehäusebodens 13 erstreckt, austreten. Der Eintritt der flüssigen Vergussmasse in den Kanal innerhalb des Stützelements 14 kann über eine Eintrittsöffnung 17 in der Abschlussfläche des Stützelements erfolgen.

Die vergossene elektronische Vorrichtung 1 weist erstarrte Vergussmasse bevorzugt in einem Volumen (ersten Teilvolumen) des Gehäuses 2 auf, das sich zwischen der, der zweiten Öffnung 6 zugewandten Seite der Leiterplatte 3 und einer Innenwand des Gehäuses 2 erstreckt. Die vergossene elektronische Vorrichtung 1 nach einem weiteren Ausführungsbeispiel weist erstarrte Vergussmasse in einem Volumen (zweiten Teilvolumen) des Gehäuses 2 auf, das sich zwischen der, der zweiten Öffnung 6 abgewandten Seite der Leiterplatte 3, einer Innenfläche einer Gehäuseseitenwand 15 und der ersten Öffnung 5 erstreckt, auf.

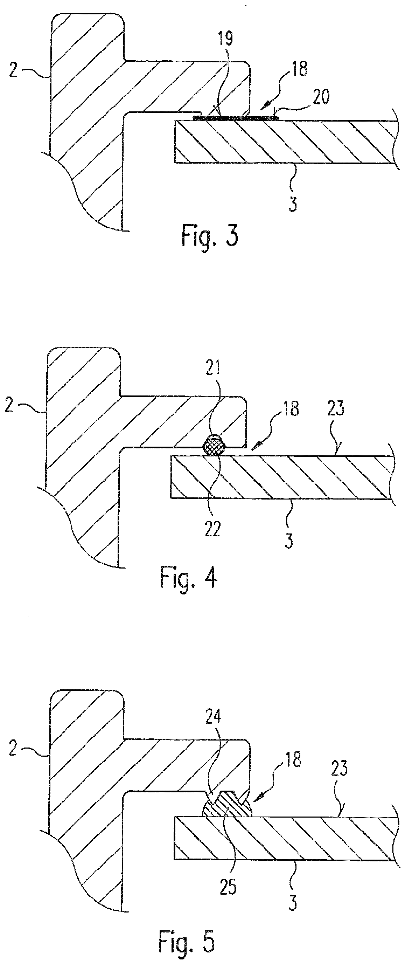

In einem, in Figur 2 mit A gekennzeichneten Zeichenbereich ist eine Dichtungsanordnung 18 gemäß einer besonders bevorzugten Ausführung der Erfindung gezeigt. Unterschiedlich ausgebildete Dichtungsanordnungen 18 werden in den Figuren 3, 4 und 5 in vergrößerter Ansicht des Zeichenbereichs A näher gezeigt.

Bei Vergiessen der elektronischen Vorrichtung 1, kann flüssige Vergussmasse in einem Spalt zwischen der zweiten Öffnung 6 und dem Gehäuses 2 durch die zweite Öffnung 6 austreten. In der Folge kann beispielsweise ein Kontaktelement 7 mit überschüssiger, fester Vergussmasse zumindest teilweise bedeckt sein. Eine elektrische Kontaktierung mittels einer Leiterader ist nachträglich nicht mehr möglich. Um diesen Austritt flüssiger Vergussmasse durch die zweite Öffnung 6 zu verhindern, ist eine Dichtungsanordnung 18 vorgesehen. Die Dichtungsanordnung 18 umgibt dabei die zweite Öffnung 6 und erfüllt die Funktion, einen Austritt von flüssiger Vergussmasse durch einen um die zweite Öffnung 6 umgebenden Spalt zwischen der Leiterplatte 3 einerseits und dem Gehäuse 2 andererseits zu verhindern. Der die zweite Öffnung 6 umgebende Spalt erstreckt sich insbesondere zwischen einem die zweite Öffnung 6 umgebenden Rand des Gehäuses 2 einerseits und andererseits der der zweiten Öffnung 2 zugewandten Oberfläche der Leiterplatte 3. Die Dichtungsanordnung 18 entsprechend einer Ausführung der Erfindung umgibt daher die zweite Öffnung 6 und dichtet die Leiterplatte 3 gegen das Gehäuse 2 ab.

Gemäß der in Figur 3 dargestellten Ausführungsform weist die Dichtungsanordnung 18 eine plane Fläche 19, auf der, der eingesetzten Leiterplatte 3 zugewandten Fläche des Gehäuses 2 und umlaufend um die zweite Öffnung 6 auf. Die plane Fläche 18 an dem Gehäuse 2 wirkt mit einer Fläche 20 auf der der zweiten Öffnung 6 zugewandten Seite der Leiterplatte 3 so zusammen, das ein Durchtritt von flüssiger Vergussmasse vermieden wird. Die Wirkung der Dichtungsanordnung 18 gemäß dem in Figur 3 dargestellten Ausführungsbeispiel ist insbesondere auch mit einer zusätzlichen Kraft auf die Leiterplatte 3 in Richtung auf die zweite Öffnung erhöht. Eine entsprechende Kraft (Flächenpressung) auf die Leiterplatte 3 kann insbesondere durch ein Haltelement, das sich an dem Gehäuse 2 abstützt, auf die Leiterplatte 3 ausgeübt werden. Das Haltelement ist dafür ausgelegt, die Leiterplatte 3 nach dem Einsetzen in das Gehäuse 2 mechanisch in der gewünschten Lage zu fixieren. Ein Halteelement kann beispielsweise durch eine in den Innenraum vorspringende, federnde Nase realisiert werden.

Gemäß der in Figur 4 dargestellten Ausführungsform weist die Dichtungsanordnung 18 eine umlaufende Nut 21 auf der der eingesetzten Leiterplatte 3 zugewandten Fläche des Gehäuses 2 und ringförmig um die zweite Öffnung 6 auf. In die Nut 21 an dem Gehäuse 2 ist eine Dichtschnur 22 (Dichtfaden) eingelegt. In Verbindung mit der Fläche 23 auf der der zweiten Öffnung 6 zugewandten Seite der Leiterplatte 3 wird der Durchtritt von flüssiger Vergussmasse durch die zweite Öffnung 6 mittels der Dichtschnur 22 vermieden. Die Wirkung der Dichtungsanordnung 18 gemäß dem in Figur 4 dargestellten Ausführungsbeispiel mittels Dichtschnur 22 ist insbesondere auch mit einer zusätzlichen Kraft auf die Leiterplatte 3 in Richtung auf die zweite Öffnung 6 hoch.

Gemäß der in Figur 5 dargestellten Ausführungsform weist die Dichtungsanordnung 18 zwei umlaufende Stege 24 auf der der eingesetzten Leiterplatte 3 zugewandten Fläche des Gehäuses 2 rings um die zweite Öffnung 6 auf. Es kann entsprechend anderen Ausführungen des erfindungsgemäßen Gehäuses 2 auch ein Steg 24 oder es können mehrere parallele Stege 24 um die zweite Öffnung 6 vorgesehen werden. Der oder die Stege 24 können dabei einen im Wesentlichen trapezförmigen oder auch keilförmigen Querschnitt aufweisen. In Verbindung mit der Fläche 23 auf der der zweiten Öffnung 6 zugewandten Seite der Leiterplatte 3 wird der Durchtritt von flüssiger Vergussmasse durch die zweite Öffnung 6 mittels des Stegs 24 vermieden. Die Wirkung der Dichtungsanordnung 18 mit der in Figur 4 dargestellten Ausführung mit einem oder mehreren Stegen 24 ist insbesondere dann vorteilhaft, wenn auf der Fläche 23 in dem Bereich der Leiterplatte 3, die mit dem Steg 24 nach Einsetzen der Leiterplatte 3 in das Gehäuse 2 unmittelbar angrenzt, eine Dichtmasse 25 aufgetragen ist. Die Dichtmasse 25 wird bevorzugt vor Einsetzen der Leiterplatte 3 in das Gehäuse 2 auf dem mit dem Steg 24 korrespondierenden Bereich der Leiterplatte 3 aufgebracht.

Die Dichtmasse 25 kann in einer weiteren Ausführung zusätzlich oder alternativ auch auf einer umlaufenden Fläche auf der, der Leiterplatte 3 zugewandten Innenfläche des Gehäuses 2 aufgebracht werden.

Die Dichtmasse 25 ist lediglich für das Vergießen der Leiterplatte im Rahmen der Herstellung der elektronischen Vorrichtung 1 vorgesehen. Der dauerhafte Schutz der elektronischen Vorrichtung 1 vor dem Eindringen von Feuchtigkeit kann mittels der Vergussmasse erfolgen.

Die Funktion der Dichtmasse 25 kann ebenfalls über einen Klebstoff, die zugleich die Leiterplatte 3 in dem Gehäuse 2 in ihrer Position festhält, geleistet werden. Mittels Kleben werden die Leiterplatte 3 und das Gehäuse 2 stoffschlüssig verbunden. Zugleich wird dabei eine abdichtende Wirkung gegen einen Durchtritt von flüssiger Vergussmasse durch die zweite

Öffnung unterbunden. Dabei ist die Wahl des geeigneten Klebstoffs durch die Beständigkeit des in der Fertigung nachfolgenden Vergießens und Aushärtens bestimmt.

Die vorstehend dargestellten Merkmale sind in dem Rahmen der in den Patentansprüchen definierten Erfindung in vorteilhafter Weise miteinander kombinierbar.

## Patentansprüche

1. Elektronische Vorrichtung umfassend eine Leiterplatte (3) und ein Gehäuse (2) zur Aufnahme der Leiterplatte (2), wobei das Gehäuse (2) eine erste Öffnung (5) zum Einsetzen der Leiterplatte (3) hat und die eingesetzte Leiterplatte (3) diese Öffnung (5) des Gehäuses (2) im Wesentlichen verschließt, wobei
zumindest ein Mittel (3, 12, 17) zum Durchtritt von Vergussmasse vorhanden ist, durch das beim Vergießen des Gehäuses (2) ein Volumen befüllbar ist, das nach dem Einsetzen der Leiterplatte (3) in das Gehäuse (2) zwischen der Leiterplatte (3) und dem Gehäuse (2) besteht,
**dadurch gekennzeichnet, dass**
eine Dichtungsanordnung (18) eine zweite Öffnung (6) des Gehäuses (2) umgibt, wobei die Dichtungsanordnung (18) die Leiterplatte (3) gegen das Gehäuse (2) abdichtet, so dass nach dem Einsetzen der Leiterplatte (3) in das Gehäuse (2) bei Vergießen der elektronischen Vorrichtung (1) eine flüssige Vergussmasse durch die zweite Öffnung (6) aus dem Gehäuse (2) nicht austritt,
die zweite Öffnung (6) in dem Gehäuse (2) so positioniert ist, dass ein mit der Leiterplatte (3) verbundenes Kontaktelement (7), Einstellelement (8) und/oder Anzeigeelement durch die zweite Öffnung (6) nach dem Einsetzen der Leiterplatte (3) in das Gehäuse (2) und dem Vergießen zugänglich ist,
das Gehäuse (2) Stützelemente (14) aufweist, deren zu der ersten Öffnung (5) hin gerichtete Abschlussfläche zumindest teilweise die Leiterplatte (3) stützt, wobei
die Stützelemente (14) hohl ausgebildet sind,
Durchtrittsöffnungen (16) in einer Umfangsfläche der Stützelemente (14) einen Austritt der Vergussmasse in das Volumen, das nach dem Einsetzen der Leiterplatte (3) in das Gehäuse (2) zwischen der Leiterplatte (3) und dem Gehäuse (2) besteht, ermöglichen, und
der Eintritt der Vergussmasse in das hohle Stützelement (14) über eine Eintrittsöffnung (17) in der Abschlussfläche des Stützelements (14) erfolgen kann.

2. Elektronische Vorrichtung nach Anspruch 1,
**dadurch gekennzeichnet, dass**
die Dichtungsanordnung (18) eine plane Fläche des Gehäuses (2) umfasst, die mit einer korrespondierenden Fläche der Leiterplatte (3) dichtend zusammenwirkt.

3. Elektronische Vorrichtung nach Anspruch 1 oder 2,
**dadurch gekennzeichnet, dass**
die Dichtungsanordnung (18) mindestens einen Steg (24) mit keilförmigem und/oder trapezförmigem Querschnitt umfasst.

4. Elektronische Vorrichtung nach einem der Ansprüche 1 bis 3,
**dadurch gekennzeichnet, dass**
die Dichtungsanordnung (18) mindestens eine Dichtschnur (22) umfasst.

5. Elektronische Vorrichtung nach einem der Ansprüche 1 bis 4,
**dadurch gekennzeichnet, dass**
die Dichtungsanordnung (18) eine Dichtmasse (25) umfasst, die nach dem Einsetzen der Leiterplatte (3) mit dem Gehäuse (2) dichtend zusammenwirkt.

6. Elektronische Vorrichtung nach einem der vorhergehenden Ansprüche,
**dadurch gekennzeichnet, dass**
zumindest ein Halteelement ausgebildet ist, das eine Kraft auf die Leiterplatte (3) in eine Richtung auf die zweite Öffnung (6) zu ausübt.

7. Elektronische Vorrichtung nach einem der vorhergehenden Ansprüche, **dadurch gekennzeichnet, dass**
das Gehäuse (2) trogförmig ausgebildet ist.

8. Elektronische Vorrichtung nach einem der Ansprüche 1 bis 7,
**dadurch gekennzeichnet, dass**
das Gehäuse (2) die mindestens eine zweite Öffnung (6) in einem ersten Bereich des Gehäuses (2) aufweist, und
ein zweiter Bereich des Gehäuses (2) eine größere Tiefe als der erste Bereich des Gehäuses (2) hat.

9. Elektronische Vorrichtung nach einem der vorhergehenden Ansprüche, **dadurch gekennzeichnet, dass**
das Gehäuse (2) in dem Volumen zwischen dem Gehäuse (2) und der Leiterplatte (3), und mindestens teilweise in einem weiteren Volumen zwischen der Leiterplatte (3) und der ersten Öffnung (5) mit der Vergussmasse befüllt ist.

10. Elektronische Vorrichtung nach einem der vorhergehenden Ansprüche, **dadurch gekennzeichnet, dass**
das Mittel zum Durchtritt der Vergussmasse zumindest eine Öffnung (12) und/oder Ausnehmung der Leiterplatte (3) umfasst.

11. Elektronische Vorrichtung nach einem der vorhergehenden Ansprüche, **dadurch gekennzeichnet, dass**
das Mittel zum Durchtritt der Vergussmasse zumindest eine Öffnung und/oder Ausnehmung und/oder Kanal des Gehäuses (2) umfasst.

12. Elektronische Vorrichtung nach einem der vorhergehenden Ansprüche, **dadurch gekennzeichnet, dass**
die elektronische Vorrichtung (1) ein Steuergerät und/oder ein Betriebsgerät ist.

## Claims

1. Electronic apparatus comprising a circuit board (3) and a housing (2) for receiving the circuit board (2), wherein the housing (2) has a first opening (5) for inserting the circuit board (3) and the inserted circuit board (3) substantially closes this opening (5) of the housing (2), wherein
there is at least one means (3, 12, 17) for the passage of casting compound through which a volume, which exists between the circuit board (3) and the housing (2) after the insertion of the circuit board (3) into the housing (2), can be filled when the housing (2) is cast,
**characterized in that**
a seal assembly (18) surrounds a second opening (6) of the housing (2), wherein the seal assembly (18) seals the circuit board (3) against the housing (2) such that, after insertion of the circuit board (3) into the housing (2), a liquid casting compound does not escape from the housing (2) through the second opening (6) when the electronic apparatus (1) is cast,
the second opening (6) is positioned in the housing (2) such that a contact element (7), setting element (8) and/or display element connected to the circuit board (3) is accessible through the second opening (6) after insertion of the circuit board (3) into the housing (2) and casting,
the housing (2) comprises support elements (14), the end face of which directed toward the first opening (5) at least partially supports the circuit board (3), wherein
the support elements (14) are hollow,
passage openings (16) in a peripheral surface of the support elements (14) allow the casting compound to escape into the volume which exists between the circuit board (3) and the housing (2) after the insertion of the circuit board (3) into the housing (2), and
the entry of the casting compound into the hollow support element (14) can take place via an entry opening (17) in the end face of the support element (14).

2. Electronic apparatus according to Claim 1,
**characterized in that**
the seal assembly (18) includes a planar surface of the housing (2) which cooperates in a sealing manner with a corresponding surface of the circuit board (3).

3. Electronic apparatus according to Claim 1 or 2,
**characterized in that**
the seal assembly (18) includes at least one web (24) having a wedge-shaped and/or trapezoidal cross-section.

4. Electronic apparatus according to any one of Claims 1 to 3,
**characterized in that**
the seal assembly (18) includes at least one sealing cord (22).

5. Electronic apparatus according to any one of Claims 1 to 4,
**characterized in that**
the seal assembly (18) includes a sealing compound (25) which cooperates in a sealing manner with the housing (2) after insertion of the circuit board (3).

6. Electronic apparatus according to any one of the preceding claims,
**characterized in that**
at least one holding element is configured, which exerts a force on the circuit board (3) in a direction toward the second opening (6).

7. Electronic apparatus according to any one of the preceding claims,
**characterized in that**
the housing (2) is trough-shaped.

8. Electronic apparatus according to any one of Claims 1 to 7,
**characterized in that**
the housing (2) comprises the at least one second opening (6) in a first region of the housing (2), and
a second region of the housing (2) has a greater depth than the first region of the housing (2).

9. Electronic apparatus according to any one of the preceding claims,
**characterized in that**
the housing (2) is filled with the casting compound in the volume between the housing (2) and the circuit board (3), and at least partially in a further volume between the circuit board (3) and the first opening (5).

10. Electronic apparatus according to any one of the preceding claims,
**characterized in that**
the means for the passage of the casting compound includes at least one opening (12) and/or recess of the circuit board (3).

11. Electronic apparatus according to any one of the preceding claims,
**characterized in that**
the means for the passage of the casting compound includes at least one opening and/or recess and/or channel of the housing (2).

12. Electronic apparatus according to any one of the preceding claims,
**characterized in that**
the electronic apparatus (1) is a control device and/or an operating device.

## Revendications

1. Dispositif électronique comprenant une carte de circuit imprimé (3) et un boîtier (2) destiné à loger la carte de circuit imprimé (2), ledit boîtier (2) présentant une première ouverture (5) permettant l'introduction de ladite carte de circuit imprimé (3), et ladite carte de circuit imprimé (3) introduite obturant sensiblement ladite ouverture (5) du boîtier (2),
au moins un moyen (3, 12, 17) de pénétration de matière d'enrobage étant prévu, lequel permet, lors de l'enrobage du boîtier (2), de remplir un volume existant dans le boîtier (2) entre la carte de circuit imprimé (3) et ledit boîtier (2) après l'introduction de la carte de circuit imprimé (3),
**caractérisé en ce que**
un dispositif d'étanchéité (18) entoure une deuxième ouverture (6) du boîtier (2), ledit dispositif d'étanchéité (18) assurant l'étanchéité de la carte de circuit imprimé (3) vis-à-vis du boîtier (2) de telle manière que, après l'introduction de la carte de circuit imprimé (3) dans le boîtier (2), aucune matière d'enrobage liquide ne sorte du boîtier (2) par la deuxième ouverture (6) lors de l'enrobage du dispositif électronique (1),
la deuxième ouverture (6) est située dans le boîtier (2) de telle manière qu'un élément de contact (7), un élément de réglage (8) et/ou un élément d'affichage (6) reliés à la carte de circuit imprimé (3) soient accessibles à travers la deuxième ouverture (6) après l'introduction de la carte de circuit imprimé (3) dans le boîtier (2) et après ledit enrobage,
le boîtier (2) présente des éléments de support (14) dont la surface terminale orientée vers la première ouverture (5) supporte au moins partiellement la carte de circuit imprimé (3), étant entendu que
les éléments de support (14) sont creux,
des ouvertures de passage (16) ménagées dans une surface périphérique des éléments de support (14) permettent une sortie de la matière d'enrobage dans ledit volume existant entre la carte de circuit imprimé (3) et le boîtier (2) après l'introduction de la carte de circuit imprimé (3) dans ledit boîtier (2), et
l'entrée de la matière d'enrobage dans l'élément de support (14) creux est possible grâce à une ouverture d'entrée (17) ménagée dans la surface terminale de l'élément de support (14).

2. Dispositif électronique selon la revendication 1,
**caractérisé en ce que**
le dispositif d'étanchéité (18) comprend une surface plane du boîtier (2) qui coopère avec une surface correspondante de la carte de circuit imprimé (3) à des fins d'étanchéité.

3. Dispositif électronique selon la revendication 1 ou 2,
**caractérisé en ce que**
le dispositif d'étanchéité (18) comprend au moins un relief (24) dont la section transversale est en forme de coin et/ou de trapèze.

4. Dispositif électronique selon l'une des revendications 1 à 3,
**caractérisé en ce que**
le dispositif d'étanchéité (18) comprend au moins un cordon d'étanchéité (22).

5. Dispositif électronique selon l'une des revendications 1 à 4,
**caractérisé en ce que**
le dispositif d'étanchéité (18) comprend une matière d'étanchéité (25) qui, après l'introduction de la carte de circuit imprimé (3), coopère avec le boîtier (2) à des fins d'étanchéité.

6. Dispositif électronique selon l'une des revendications précédentes,
**caractérisé en ce que**
il est formé au moins un élément de retenue qui exerce, sur la carte de circuit imprimé (3), une force orientée vers la deuxième ouverture (6).

7. Dispositif électronique selon l'une des revendications précédentes,
**caractérisé en ce que**
le boîtier (2) est en forme d'auge.

8. Dispositif électronique selon l'une des revendications 1 à 7,
**caractérisé en ce que**
le boîtier (2) présente l'au moins une deuxième ouverture (6) dans une première zone dudit boîtier (2) et
une deuxième zone dudit boîtier (2) a une profondeur supérieure à celle de la première zone dudit boîtier (2).

9. Dispositif électronique selon l'une des revendications précédentes,
**caractérisé en ce que**
le boîtier (2) est rempli de matière d'enrobage dans le volume situé entre le boîtier (2) et la carte de circuit imprimé (3) et, au moins partiellement, dans un autre volume situé entre la carte de circuit imprimé (3) et la première ouverture (5).

10. Dispositif électronique selon l'une des revendications précédentes,
**caractérisé en ce que**
le moyen de pénétration de matière d'enrobage comprend au moins une ouverture (12) et/ou un évidement réalisés dans la carte de circuit imprimé (3).

11. Dispositif électronique selon l'une des revendications précédentes,
**caractérisé en ce que**
le moyen de pénétration de matière d'enrobage comprend au moins une ouverture et/ou un évidement et/ou un canal réalisés dans le boîtier (2).

12. Dispositif électronique selon l'une des revendications précédentes,
**caractérisé en ce que**
le dispositif électronique (1) est un appareil de contrôle et/ou un appareillage.
